# EUROPEAN PATENT APPLICATION

(11) **EP 2 529 926 A1**
(43) Date of publication of application: **05.12.2012**
(21) Application number: 11736999.1
(22) Date of filing: 25.01.2011
(51) Int. Cl.: B32B 27/00, B32B 15/082, C23C 14/06, C23C 14/08

(54) **GAS BARRIER FILM, PRODUCTION METHOD THEREFOR, AND DEVICE USING SAME**

(30) Priority: 27.01.2010 JP 2010015778
(71) Applicant: Daicel Corporation, Osaka-shi, Osaka 530-0001 (JP); Daicel Value Coating Ltd., Tokyo 108-8232 (JP)
(72) Inventor: NAKAMURA Shuji, Himeji-shi Hyogo 671-1283 (JP); YUKAMI Yoshikazu, Himeji-shi Hyogo 671-1283 (JP); NISHIMURA Kanae, Amagasaki-shi Hyogo 661-0964 (JP)
(74) Representative: Grünecker, Kinkeldey, Stockmair & Schwanhäusser
(86) International application number: PCT/JP2011/051352
(87) International publication number: WO 2011/093286

(57) **Abstract**

A gas barrier film having excellent gas barrier properties (e.g. , barrier properties against water vapor) , a production process of the film, and a device provided with the film are provided.

A gas barrier film 10 having high gas barrier properties (e.g., barrier properties against water vapor) is obtainable by forming an anchor layer 12 on at least one side of a base film 11 and forming a barrier layer 13 on the anchor layer, wherein the anchor layer is formed from a cured product of a polymerizable composition containing at least a silicone (meth) acrylate monomer and/or prepolymer, and the barrier layer contains a metal or a metal compound.

## Description

### TECHNICAL FIELD

The present invention relates to a film having excellent gas barrier properties (for example, barrier properties against water vapor) and a process for producing the film, as well as a device (an electronic device such as a liquid crystal element, a thin-film solar cell, an organic EL device, or an electronic paper) provided with the film as a gas barrier member.

### BACKGROUND ART

Significant improvement in gas barrier properties by covering (or coating) a base film with a thin film of a metal or a metal compound is being attempted. For example, Japanese Patent Application Laid-Open Publication No. 2005-178137 (JP-2005-178137A, Patent Document 1) discloses a gas barrier film which comprises a base film, a barrier vapor deposition layer having a smooth surface stacked on at least one side of the base film, and an acid-resistant protective layer having a smooth surface stacked on the barrier vapor deposition layer. This document discloses that the protective layer may comprise an acrylate polymer. Moreover, this document discloses an extremely excellent gas barrier film having a moisture vapor transmission rate of not more than 0.1 g/m²/day. However, in order to express high gas barrier properties, it is necessary to smooth the surface of the barrier vapor deposition layer and that of the protective layer, and it is difficult to produce the gas barrier film simply.

Japanese Patent Application Laid-Open Publication No. 2005-528250 (JP-2005-528250A, Patent Document 2) discloses a multi-layer barrier coating, comprising (i) a flexible base, (ii) a foundation stack, comprising a foundation barrier layer deposited over the flexible base, and an organic layer deposited over the foundation barrier layer, (iii) a barrier stack being deposited over the foundation stack and comprising a barrier-stack barrier layer and an organic layer deposited over the barrier-stack barrier layer, (iv) a topmost isolation layer deposited over the barrier stack. This document discloses that the organic layer may contain an acrylate-based organic material.

Further, Japanese Patent Application Laid-Open Publication No. 2004-9395 (JP-2004-9395A, Patent Document 3) discloses a transparent water vapor barrier film having a barrier film comprising at least an inorganic matter layer/an organic matter layer/an inorganic matter layer on a polymer base and discloses that the organic matter layer is made mainly of a crosslinked diacrylate polymer having at least one polar group except acryloyl group. This document discloses that the polar group preferably has an ether bond and/or an ester bond from the aspect of transparency or heat stability.

However, these films have insufficient barrier properties against water vapor. Moreover, the formation of the inorganic material layer by deposition and the formation of the organic material layer on the inorganic material layer by deposition improve transparency, but induce a lowered productivity.

Meanwhile, a gas barrier film in which a barrier layer containing a metal or a metal compound is stacked on a base film through an acrylic polymer layer is also known. For example, Japanese Patent Application Laid-Open Publication No. 10-278167 (JP-10-278167A, Patent Document 4) discloses a barrier stack having a structure in which an acryl polymer layer formed by a vacuum ultraviolet curing method and a vapor deposition thin film of a metal or a metal compound are stacked in order on one side of a polymer film. This document discloses a wide range of an acrylic monomer or oligomer, and also exemplifies a urethane acrylate or a silicone acrylate. However, the barrier stack cannot reduce the moisture vapor permeability and cannot improve the gas barrier properties. For example, in Examples of this document, the barrier stack has a moisture vapor transmission rate (40°C, 90%RH) of 0.4 g/m²/day, which is insufficient against gas barrier properties required for a device member in recent years.

Moreover, Japanese Patent Application Laid-Open Publication No. 2005-313560 (JP-2005-313560A, Patent Document 5) discloses a gas barrier film having lamination unit(s), in which a 0.1- to 10-µm-thick acrylic polymer layer made of a cured product of an ultraviolet-curable polymer containing only an acrylic monomer and/or an acrylic polymerizable prepolymer as a polymerizable component and a 20- to 100-nm-thick inorganic barrier layer are sequentially stacked from a closer side to a flexible base, and this lamination unit is formed once or more repeatedly directly on one side or both sides of the flexible base. This document discloses a wide range of an acrylic monomer or an acrylic polymerizable prepolymer, and also exemplifies a urethane acrylate or a silicone acrylate. However, this gas barrier film also has insufficient barrier properties against water vapor. For example, in Examples of this document, the gas barrier film has a high moisture vapor permeability (40°C, 100%RH) of 0.49g/m²·day. In particular, even when the gas barrier film has the inorganic barrier layer formed on each side of the base film through the acrylic polymer layer, the film has a moisture vapor permeability (40°C, 100%RH) of 0.09 g/m²·day.

### RELATED ART DOCUMENTS

### PATENT DOCUMENTS

Patent Document 1: JP-2005-178137A (Claims 1 and 10, Paragraph [0037], and Examples)
Patent Document 2: JP-2005-528250A (Claim 1 and Paragraph [0035])
Patent Document 3: JP-2004-9395A (Claims 1 and 2 and Paragraph [0007])
Patent Document 4: JP-10-278167A (Claim 1, Paragraph [0036], and Examples)
Patent Document 5: JP-2005-313560A (Claim 1, Paragraph [0033], and Examples)

### SUMMARY OF THE INVENTION

### PROBLEMS TO BE SOLVED BY THE INVENTION

It is therefore an object of the present invention to provide a gas barrier film having excellent gas barrier properties (for example, barrier properties against water vapor), a process for producing the film, and a device provided with the film.

Another object of the present invention is to provide a gas barrier film having a high transparency, a process for producing the film, and a device provided with the film.

It is still another object of the present invention to provide a gas barrier film having anticurling properties and a high adhesion between a base film and a barrier layer, a process for producing the film, and a device provided with the film.

### MEANS TO SOLVE THE PROBLEMS

The inventors of the present invention made extensive studies and finally found that the formation of an anchor layer from a composition containing at least a silicone (meth)acrylate monomer and/or prepolymer on at least one side of a base film and the formation of a barrier layer containing a metal or a metal compound on the anchor layer allows the gas barrier properties (barrier properties against water vapor) of the resulting film to be improved markedly. The present invention was accomplished based on the above findings.

That is, the gas barrier film of the present invention has a stacked structure (or a laminated structure) comprising a base film, an anchor layer formed (or stacked or laminated) on at least a first side (surface) of the base film, and a barrier layer formed (or stacked or laminated) on the anchor layer; the anchor layer is formed from a cured product of a polymerizable composition containing a vinyl monomer and/or a vinyl prepolymer (oligomer), and the barrier layer contains a metal or a metal compound. In the gas barrier film, the vinyl monomer and/or prepolymer comprise at least a silicone (meth)acrylate monomer and/or prepolymer [for example, combination of a silicone (meth)acrylate monomer and/or prepolymer and a silicon-free vinyl monomer and/or prepolymer (e.g., a urethane (meth)acrylate)].

The ratio (weight ratio) of the silicone (meth)acrylate monomer and/or prepolymer relative to the silicon-free vinyl monomer and/or prepolymer is not particularly limited to a specific one. Even when the ratio is about 1/99 to 30/70 as a ratio of the former/the latter, the film achieves high gas barrier properties.

The base film may comprise at least one member selected from the group consisting of a polyester and a polycarbonate. Moreover, the first side of the base film may have a plurality of the units (lamination units or repeating units) in the form of stacking, each unit composed of the anchor layer and the barrier layer formed on the anchor layer. The barrier layer may contain at least one metal compound selected from the group consisting of a metal oxide, a metal oxynitride, and a metal nitride. The barrier layer may be formed by a film-forming means selected from the group consisting of a vacuum deposition, an ion plating, a sputtering, a chemical vapor deposition, and others. The barrier layer may have a thickness of about 20 to 300 nm.

The gas barrier film of the present invention may further comprises at least one layer selected from the group consisting of a coat layer (such as a hardcoat layer or an overcoat layer) and a conductive (or electro-conductive) layer (such as a transparent conductive layer). A hardcoat layer which is formed from a cured product of polymerizable composition containing a vinyl monomer and/or a vinyl prepolymer may be formed on a second side (surface) of the base film (a surface opposite to the surface having the anchor layer formed thereon). An overcoat layer formed from an organic material may be formed on the barrier layer. A conductive layer may be formed as at least one outermost layer.

The present invention also includes a process for producing the gas barrier film; the process comprises forming an anchor layer by applying a polymerizable composition at least containing a silicone (meth)acrylate monomer and/or a silicone (meth)acrylate prepolymer on at least a first side of a base film and then curing the polymerizable composition, and forming a barrier layer containing a metal or a metal compound on the anchor layer.

Moreover, the gas barrier film of the present invention is preferably available for an electronic device (e.g., a liquid crystal element, a thin-film solar cell, and an organic EL device, electronic paper) as a gas barrier member.

Throughout this description, a (meth)acrylate is used as a generic term for an acrylate and a methacrylate; and a (meth) acrylic is used as a generic term for an acrylic and a methacrylic. Moreover, throughout this description, the term "vinyl" is used as the meaning of a generic term for a compound having **α,β**-ethylenic unsaturated double bond(s).

### EFFECTS OF THE INVENTION

According to the present invention, when an anchor layer being interposed between a base film and a barrier layer and formed from a cured product of a polymerizable composition containing at least a silicone (meth)acrylate monomer and/or prepolymer, the resulting film has markedly improved gas barrier properties (for example, barrier properties against water vapor). In particular, even when the silicone (meth)acrylate monomer and/or prepolymer content of the film is low, the gas barrier properties of the film are markedly improved. Accordingly, use of the gas barrier film of the present invention as a gas barrier member for an electronic device prevents the device performance of the electronic device from deteriorating due to external water vapor. Moreover, when the barrier layer composed of a metal compound comprising aluminum, silicon, or the like (for example, a metal oxide, a metal oxynitride, and a metal nitride) is formed by a physical vapor deposition or a chemical vapor deposition, the resulting film has not only improved gas barrier properties but also improved transparency. Further, the gas barrier film of the present invention is preventable from curling by, for example, forming a coat layer (such as a hardcoat layer) on one side of the base film, where the anchor layer is formed on the other side of the base film. In addition, the adhesion of the barrier layer to the base film is improbable.

### BRIEF DESCRIPTION OF DRAWINGS

[Fig. 1] Fig. 1 is a schematic cross-sectional view showing a gas barrier film in accordance with an embodiment of the present invention.
[Fig. 2] Fig. 2 is a schematic cross-sectional view showing a gas barrier film in accordance with another embodiment of the present invention.
[Fig. 3] Fig. 3 is a schematic cross-sectional view showing a gas barrier film in accordance with still another embodiment of the present invention.
[Fig. 4] Fig. 4 is a schematic cross-sectional view showing an organic EL device provided with a gas barrier film as a gas barrier member in accordance with an embodiment of the present invention.

### DESCRIPTION OF EMBODIMENTS

Hereinafter, the present invention will be explained in detail with reference to the attached drawings if necessary.

### [Gas barrier film]

The gas barrier film of the present invention has a stacked (or laminated) structure which comprises a base film, an anchor layer formed on at least one side of the base film, and a barrier layer formed on the anchor layer, wherein the anchor layer is formed from a cured product of a polymerizable composition containing at least a silicone (meth)acrylate monomer and/or prepolymer (hereinafter, may be referred to as a "silicone (meth)acrylate component" generically) as a vinyl (in particular, (meth)acrylic) monomer and/or prepolymer (hereinafter, may be referred to as a "vinyl component ((meth)acrylic component)" generically), and the barrier layer contains a metal or a metal compound.

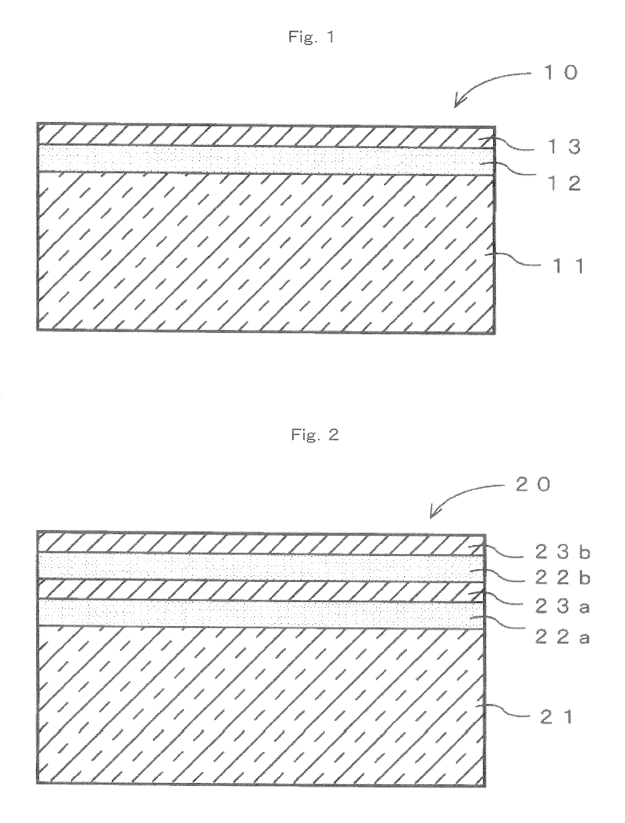

Fig. 1 is a schematic cross-sectional view showing a gas barrier film in accordance with an embodiment of the present invention. In this embodiment, an anchor layer 12 is formed on a first side of a base film 11, and a barrier layer 13 is formed on the anchor layer 12.

Since the anchor layer interposed between the base film and the barrier layer is composed of a specified vinyl component, the gas barrier film has extremely high gas barrier properties (for example, barrier properties against water vapor).

Incidentally, in order to better prevent curling of the film, a coat layer (for example, a hardcoat layer) which is formed from a cured product of a polymerizable composition containing a vinyl monomer and/or prepolymer may be formed on a second side of the base film. Moreover, in order to prevent curling of the film and better improve the gas barrier properties of the film, the barrier layer may be formed on each side of the base film through the anchor layer.

Fig. 2 is a schematic cross-sectional view showing a gas barrier film in accordance with another embodiment of the present invention. In this embodiment, an anchor layer 22a is formed on a first side of a base film 21, a barrier layer 23a is formed on the anchor layer 22a, and further, an anchor layer 22b is formed on the barrier layer 23a, and a barrier layer 23b is formed on the anchor layer 22b.

Since the anchor layer and the barrier layer are stacked alternately and repeatedly, the gas barrier film has markedly improved gas barrier properties.

Incidentally, the anchor layer and the barrier layer formed on the anchor layer may form a stack (or lamination) unit (a repeating unit), and a plurality (not less than 2) of the units may be stacked on the first side of the base film. For example, the number of units on the first side of the base film may be about 2 to 20, preferably about 2 to 15, and more preferably about 2 to 10. In this case, respective barrier layers may be the same or different (for example, in composition, thickness, or others) from each other. Respective anchor layers may also be the same or different from each other.

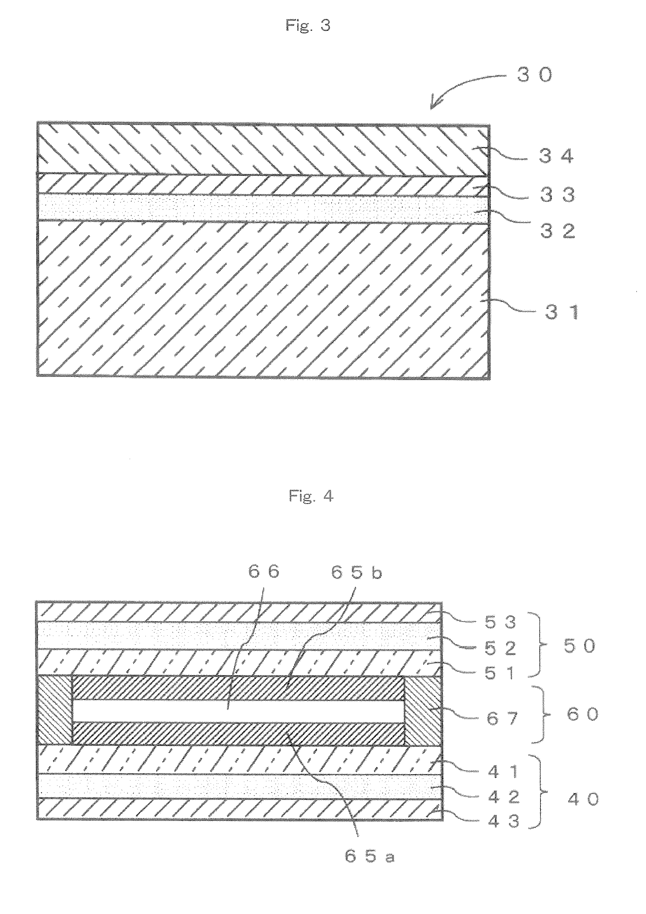

Fig. 3 is a schematic cross-sectional view showing a gas barrier film in accordance with still another embodiment of the present invention. In this embodiment, the constitution is the same as that of Fig. 1 except that an overcoat layer 34 is formed on a barrier layer 33.

For such a gas barrier film, the overcoat layer covering the barrier layer can prevent the barrier layer from cracking or having a defect even if a mechanical external force acts on the film. Thus the gas barrier film ensures high gas barrier properties over a long period of time.

Incidentally, in terms of prevention of curling of the film, a coat layer (such as a hardcoat layer) may be formed on another side (a second side) of the base film.

According to application of the gas barrier film, various layers may be formed on the gas barrier film of the present invention. Various layers are not limited to a coat layer (such as an overcoat layer or a hardcoat layer) and may include, e.g., a conductive layer (a transparent conductive layer) for use of an electronic device.

Hereinafter, each component of the gas barrier film will be explained in detail.

### [Base film]

The base film is not particularly limited to a specific one as far as the film can hold an anchor layer and a barrier layer. The base film can suitably be selected according to the purpose and is usually composed of a plastic. The plastic may be a thermoplastic polymer or a thermosetting polymer. Specifically, the plastic may include a polyolefin (e.g., a polyethylene, a polypropylene, and an amorphous polyolefin), a polystyrene (e.g., a styrene homopolymer and a acrylonitrile-styrene copolymer), a polyester [e.g., a poly(alkylene arylate) (such as a poly (ethylene terephthalate) (PET), a PET copolymer (PET-G) containing cyclohexane dimethanol as a diol component, a poly(butylene terephthalate) (PBT), or a poly(ethylene naphthalate) (PEN)), a polyarylate, and a liquid-crystalline polyester], a polyamide (e.g., a nylon 6, a nylon 66, and a nylon 12), a poly(vinyl chloride) [e.g., a vinyl chloride homopolymer], a polycarbonate (e.g., a bisphenol A-based polycarbonate), a poly(vinyl alcohol), a cellulose ester, a polyimide, a polysulfone, a poly(phenylene ether), a poly(phenylene sulfide), and a fluorine-containing polymer.

These plastics may be used alone or in combination. Among these plastics, at least one plastic selected from the group consisting of a polyester and a polycarbonate is preferred. A poly (alkylene arylate) (such as a PET or a PEN) is particularly preferred.

The glass transition temperature (Tg) of the plastic for the base film is not particularly limited to a specific one. For example, the glass transition temperature (Tg) of the plastic may be about 40 to 350°C (e.g., about 60 to 350°C), preferably about 70 to 300°C, and more preferably about 100 to 250°C.

If necessary, an additive may be added to the base film. Examples of the additive may include a stabilizer (e.g., an antioxidant, an ultraviolet ray absorbing agent, a light stabilizer, and a heat stabilizer), a nucleation agent, a flame retardant, a flame-retardant auxiliary, a filler, a plasticizer, an impact modifier, a reinforcer, a coloring agent, a dispersing agent, an antistatic agent, a foaming agent, and an antibacterial agent. These additives may be used alone or in combination.

The base film may be a non-stretched film or a stretched (uniaxially or biaxially stretched) film. Moreover, in order to improve the adhesive property, the base film may be subjected to a surface treatment [for example, a discharge treatment (such as corona discharge or glow discharge), an acid treatment, and a flame treatment].

The thickness of the base film may for example be about 1 to 500 µm (e.g., about 10 to 500 µm), preferably about 50 to 400 µm, and more preferably about 100 to 250 µm.

### [Anchor layer]

The anchor layer is formed from a cured product of a polymerizable composition containing a vinyl component. The polymerizable composition usually comprises a vinyl component and a polymerization initiator.

### (Vinyl component)

The vinyl component contains at least a silicone (meth)acrylate component. The vinyl component may comprise a silicone (meth)acrylate component alone and usually comprises a silicone (meth)acrylate component and a silicon-free vinyl (particularly, a silicon-free (meth) acrylic) monomer and/or prepolymer [hereinafter, may be referred to as a "silicon-free vinyl component (silicon-free (meth)acrylic component)" generically].

Combination of the silicon-free vinyl component and the silicone (meth)acrylate component significantly improves the gas barrier properties (for example, barrier properties against water vapor). The reason why the combination improves the gas barrier properties is not known exactly. For example, the following are the conceivable factors: a firmadhesionbetween the base film and the barrier layer through the anchor layer, improved smoothness of the anchor layer, improved denseness of the barrier layer due to the anchor layer, and others.

### (A) Silicone (meth)acrylate component

The silicone (meth)acrylate component is not particularly limitedto a specific one as far as the component is a compound (curable compound) having a silicon atom and a (meth)acryloyl group. The silicone (meth)acrylate component usually has an organosiloxane unit [-Si(-R)₂-O-] (where the group R represents a substituent). The number of Si atoms (or organosiloxane units) per molecule may be not less than 1 (for example, about 1 to 30, preferably about 1 to 20, and more preferably about 1 to 15). Moreover, the number of (meth)acryloyl groups per molecule may be not less than 1 (for example, about 1 to 20, preferably about 1 to 15, and more preferably about 1 to 10).

The silicone (meth)acrylate component may be a monomer, an oligomer (or a prepolymer), or combination of the monomer and the oligomer. Moreover, the oligomer (prepolymer) may be a polysiloxane oligomer having a plurality of (-Si-O) bonds or may be an oligomer (such as a dimer or a trimer) obtainable by hydrolytic condensation of a silicone (meth)acrylate monomer having a hydrolytically condensablegroup (e.g., a C₁₋₄alkoxy group methoxy or ethoxy, and a halogen atom such as chlorine atom).

Representative examples of the silicone (meth)acrylate component may include a silicone mono- to tetra(meth)acrylate having one Si atom per molecule and a silicone tetra- to hexa (meth) acrylate having two Si atoms per molecule.

These silicone (meth)acrylate components may be used alone or in combination. Among these silicone (meth)acrylate components, the preferred one may include a silicone (meth)acrylate component having a plurality of (e.g., about 2 to 10, preferably about 2 to 8, and more preferably about 2 to 6) (meth)acryloyl groups and one or a plurality of (e.g., about 1 to 20, preferably about 1 to 10, and more preferably about 1 to 6) Si atom(s) per molecule [for example, a silicone di- to hexa(meth) acrylate, preferably a silicone di- to tetra(meth)acrylate, and particularly a silicone di- to tri(meth)acrylate such as a silicone di(meth)acrylate]. Incidentally, the silicone di(meth)acrylate is available as the trade name "EBECRYL350" (manufactured by DAICEL-CYTEC Company, Ltd.), and others; the silicone hexa (meth) acrylate is available as the trade name "EBECRYL1360" (manufactured by DAICEL-CYTEC Company, Ltd.), and others.

The viscosity of the silicone (meth)acrylate component at 25°C may be about 100 to 5000 mPa·s, preferably about 200 to 4000 mPa·s, and more preferably about 300 to 3000 mPa·s.

The silicone (meth)acrylate component content in the whole polymerizable composition also including the additive (e.g., a polymerization initiator) can be selected from the range of not more than 50% by weight (e.g., about 1 to 30% by weight) or may be about 0.01 to 25% by weight (e.g., about 0.05 to 20% by weight), preferably about 0.1 to 15% by weight (e.g., about 0.5 to 10% by weight), and more preferably about 1 to 5% by weight (e.g., about 2 to 4% by weight).

### (B) Silicon-free vinyl component

The silicon-free vinyl component is not particularly limited to a specific one as far as the component is free from a silicon atom and is a compound (a curable compound) having an α,β-ethylenic unsaturated double bond. The number of α,β-ethylenic unsaturated double bonds [in particular, (meth)acryloyl groups] per molecule may be not less than 1 (e.g., about 1 to 20, preferably about 1 to 15, and more preferably about 1 to 10).

The silicon-free vinyl component may be a monomer, an oligomer (or a prepolymer), or combination of the monomer and the oligomer.

The silicon-free vinyl monomer may include a monofunctional vinyl monomer [e.g., a monofunctional (meth) acrylate (or a mono (meth) acrylate)], a difunctional vinyl monomer [e.g., a difunctional (meth)acrylate (or a di(meth)acrylate)], a tri- or more-functional vinyl monomer [e.g., a tri- or polyfunctional (meth)acrylate (or a poly(meth)acrylate)], and others.

The monofunctional vinyl monomer may include, for example, (meth)acrylic acid; a C₁₋₂₄alkyl (meth)acrylate such as methyl (meth)acrylate, ethyl (meth)acrylate, propyl (meth)acrylate, butyl (meth)acrylate, isobutyl (meth)acrylate, sec-butyl (meth)acrylate, t-butyl (meth)acrylate, hexyl (meth)acrylate, octyl (meth)acrylate, isooctyl (meth)acrylate, 2-ethylhexyl (meth)acrylate, decyl (meth)acrylate, lauryl (meth)acrylate, or stearyl (meth)acrylate; a cycloalkyl (meth)acrylate such as cyclohexyl (meth)acrylate; a crosslinked cyclic (meth) acrylate such as dicyclopentanyl (meth)acrylate, dicyclopentenyl (meth)acrylate, dicyclopentenyloxyethyl (meth)acrylate, bornyl (meth)acrylate, isobornyl (meth)acrylate, or tricyclodecanyl (meth)acrylate; an aryl (meth)acrylate such as phenyl (meth)acrylate or nonylphenyl (meth)acrylate; an aralkyl (meth)acrylate such as benzyl(meth)acrylate; a hydroxyC₂₋₁₀alkyl (meth)acrylate or a C₂₋₁₀alkanediol mono(meth)acrylate such as hydroxyethyl (meth)acrylate, hydroxypropyl (meth)acrylate, or hydroxybutyl (meth)acrylate; a fluoroC₁₋₁₀alkyl (meth)acrylate such as trifluoroethyl (meth)acrylate, tetrafluoropropyl (meth)acrylate, hexafluoroisopropyl (meth)acrylate; an alkoxyalkyl (meth)acrylate such as methoxyethyl (meth)acrylate; an aryloxyalkyl (meth)acrylate such as phenoxyethyl (meth)acrylate; an aryloxy(poly)alkoxyalkyl (meth)acrylate such as phenylcarbitol (meth)acrylate, nonylphenylcarbitol (meth)acrylate, or nonylphenoxypolyethylene glycol (meth)acrylate; an aryloxyhydroxyalkyl (meth)acrylate such as phenoxyhydroxypropyl (meth)acrylate; a polyalkylene glycol mono(meth)acrylate such as a polyethylene glycol mono(meth)acrylate; an alkanepolyol mono(meth)acrylate such as glycerin mono(meth)acrylate; an amino group-containing (meth)acrylate such as 2-dimethylaminoethyl (meth)acrylate, 2-diethylaminoethyl (meth)acrylate, or 2-t-butylaminoethyl (meth)acrylate; and glycidyl (meth)acrylate.

Examples of the difunctional vinyl monomer may include an allyl (meth)acrylate; an alkanediol di (meth) acrylate such as ethylene glycol di (meth) acrylate, propylene glycol di(meth)acrylate, 1,3-propanediol di(meth)acrylate, 1,4-butanediol di(meth)acrylate, neopentyl glycol di(meth)acrylate, or 1,6-hexanediol di(meth)acrylate; an alkanepolyol di(meth)acrylate such as glycerin di(meth)acrylate; a polyalkylene glycol di(meth)acrylate such as diethylene glycol di (meth) acrylate, triethylene glycol di(meth)acrylate, a polyethylene glycol di(meth)acrylate, dipropylene glycol di(meth)acrylate, or a polypropylene glycol di(meth)acrylate; a di(meth)acrylate of a C₂₋₄alkylene oxide adduct of a bisphenol compound (such as bisphenol A or S), such as 2,2-bis(4-(meth)acryloxyethoxyphenyl)propane, 2,2-bis(4-(meth)acryloxydiethoxyphenyl)propane, or 2,2-bis(4-(meth)acryloxypolyethoxyphenyl)propane; a di(meth)acrylate of an acid-modified alkanepolyol, such as a fatty-acid-modified pentaerythritol; and a crosslinked cyclic di (meth) acrylate such as tricyclodecanedimethanol di(meth)acrylate.

As the polyfunctional vinyl monomer, there may be mentioned,for example,an alkanepolyol(meth)acrylatesuch as trimethylolpropane tri(meth)acrylate, glycerin tri(meth)acrylate, pentaerythritol tri(meth)acrylate, pentaerythritol tetra(meth)acrylate, tetramethylolethane tetra(meth)acrylate, dipentaerythritol penta(meth)acrylate, or dipentaerythritol hexa (meth) acrylate; a tri (meth) acrylate of an alkanepolyol C₂₋₄alkylene oxide adduct (such as trimethylolpropane or glycerin); and a tri(meth)acrylate having a triazine ring, such as tris(2-hydroxyethyl)isocyanurate tri(meth)acrylate.

These monomers may be used alone or in combination.

The silicon-free vinyl oligomer may include a polyester (meth)acrylate [for example, a polyester (meth) acrylate producible by a reaction of a polycarboxylic acid, a polyol, and a (meth)acrylic acid and/or a hydroxyalkyl (meth)acrylate]; an alkyd polymer; an epoxy (meth)acrylate [for example, an epoxy (meth)acrylate obtainable by ring-opening addition of (meth)acrylic acid to an epoxy compound having a plurality of epoxy groups (e.g., a polyhydric-alcohol-based, polycarboxylic-acid-based, bisphenol-based (such as bisphenol A, F, or S), or novolak-based epoxy polymer)]; a urethane (meth)acrylate; a polyacryl (meth)acrylate [for example, a polyacryl(meth)acrylate obtainable by ring-opening addition of (meth)acrylic acid to an epoxy group of a copolymer of a (meth)acrylic monomer and glycidyl(meth)acrylate]; a polyether (meth)acrylate; a polybutadiene (meth)acrylate; melamine (meth)acrylate; a polyacetal (meth)acrylate; and others. These oligomers may be used alone or in combination.

Among these silicon-free vinyl components, an oligomer such as urethane (meth)acrylate is preferred in terms of flexibility or others.

The urethane (meth)acrylate is not particularly limited to a specific one. For example, the urethane (meth)acrylate may be a urethane (meth)acrylate obtained by allowing a (meth) acrylate having an active hydrogen atom [for example, a hydroxyalkyl (meth) acrylate] to react with a polyisocyanate component [or a prepolymer which is obtained by a reaction of a polyisocyanate component and a polyol component and has a free isocyanate group].

Examples of the polyisocyanate component may include an aliphatic polyisocyanate [for example, an aliphatic diisocyanate such as tetramethylene diisocyanate, hexamethylene diisocyanate (HDI), trimethylhexamethylene diisocyanate (TMDI), or lysine diisocyanate (LDI); and an aliphatic triisocyanate such as 1,6,11-undecane triisocyanate methyloctane or 1,3,6-hexamethylene triisocyanate], an alicyclic polyisocyanate [for example, an alicyclic diisocyanate such as cyclohexane 1,4-diisocyanate, isophorone diisocyanate (IPDI), hydrogenerated xylylene diisocyanate, or hydrogenerated bis(isocyanatophenyl)methane; and an alicyclic triisocyanate such as bicycloheptane triisocyanate], and an aromatic polyisocyanate [for example, an aromatic diisocyanate such as phenylene diisocyanate, tolylene diisocyanate (TDI), xylylene diisocyanate (XDI), tetramethylxylylene diisocyanate (TMXDI), naphthalene diisocyanate (NDI), bis(isocyanatophenyl)methane (MDI), toluidine diisocyanate (TODI), or 1,3-bis(isocyanatophenyl)propane; and an aromatic triisocyanate such as triphenylmethane triisocyanate]. These polyisocyanate components may be used alone or in combination.

The polyol component is not particularly limited to a specific one. For example, the polyol component may include a low molecular weight polyol [for example, an aliphatic polyol (e.g., a C₂₋₁₀alkanediol such as ethylene glycol, propylene glycol, or tetramethylene ether glycol; and a C₃₋₁₂aliphatic polyol such as glycerin, trimethylolpropane, or pentaerythritol), an alicyclic polyol (e.g., acycloalkanediol such as 1,4-cyclohexanediol, a hydrogenerated bisphenol compound such as a hydrogenerated bisphenol A, or a C₂₋₄alkylene oxide adduct thereof), an aromatic polyol (e.g., an araliphatic diol such as xylylene glycol, a bisphenol compound such as bisphenol A, S, or F, or a C₂₋₄alkylene oxide adduct thereof)], and a polymer polyol [for example, a poly(ether polyol) (e.g., a poly(C₂₋₄alkylene glycol) such as a poly(ethylene glycol), a poly(propylene glycol), or a poly(tetramethylene ether glycol)), a polyester polyol (e.g., a polyester polyol of an aliphatic dicarboxylic acid (such as adipic acid) and an aliphatic diol), and a polycarbonate polyol]. These polyol components may be used alone or in combination.

The polyisocyanate component and the (meth) acrylate having an active hydrogen atom (or the polyol component) are usually employed in combination at a ratio in which the isocyanate group and the active hydrogen atom are almost equivalent (the isocyanate group/the active hydrogen atom is about 0.8/1 to 1.2/1).

Incidentally, processes for producing these urethane (meth) acrylates may be referred to Japanese Patent Application Laid-Open No. 2008-74891, or others.

The weight-average molecular weight of the urethane (meth) acrylate may be about 500 to 10000, preferably about 600 to 9000, and more preferably about 700 to 8000 in terms of polystyrene in a gel permeation chromatography (GPC).

The ratio (weight ratio) of the silicone (meth)acrylate component relative to the silicon-free vinyl component [for example, a silicon-free (meth)acrylic component such as urethane (meth)acrylate] can be selected from the range of about 0.01/99.99 to 50/50 (e.g., about 1/99 to 30/70) as a ratio of the former/the latter. The ratio of the silicone (meth)acrylate component relative to the silicon-free vinyl component may be about 0. 01/99. 99 to 30/70 (e.g., about 0. 05/99. 95 to 25/75), preferably about 0.1/99.9 to 20/80 (e.g., about 0.5/99.5 to 15/85), and more preferably about 1/99 to 10/90 (e.g., about 1.5/98.5 to 8/92, particularly about 2/98 to 5/95). According to the present invention, even when the silicone (meth)acrylate component content is low, the gas barrier properties (barrier properties against water vapor) can significantly be improved.

### (Polymerization initiator)

The polymerization initiator may be a thermal polymerization initiator [a thermal radical generator such as a peroxide (e.g., benzoyl peroxide)] or a photopolymerization initiator (a photo radical generator). The preferred polymerization initiator includes a photopolymerization initiator. Examples of the photopolymerization initiator may include a benzoin compound (e.g., benzoin, and a benzoin alkyl ether such as benzoin methyl ether, benzoin ethyl ether, or benzoin isopropyl ether), a phenyl ketone [for example, an acetophenone compound (e.g., acetophenone, 2-hydroxy-2-methyl-1-phenylpropan-1-one, 2,2-dimethoxy-2-phenylacetophenone, 2,2-diethoxy-2-phenylacetophenone, and 1,1-dichloroacetophenone); an alkyl phenyl ketone such as 2-hydroxy-2-methylpropiophenone; and a cycloalkyl phenyl ketone such as 1-hydroxycyclohexyl phenyl ketone], an aminoacetophenone {for example, 2-methyl-1-[4-(methylthio)phenyl]-2-morpholinoaminopro panone-1,2-benzyl-2-dimethylamino-1-(4-morpholinopheny l)-butanone-1}, an anthraquinone compound (e.g., anthraquinone, 2-methylanthraquinone, 2-ethylanthraquinone, 2-t-butylanthraquinone, and 1-chloroanthraquinone), a thioxanthone compound (e.g., 2,4-dimethylthioxanthone, 2,4-diethylthioxanthone, 2-chlorothioxanthone, and 2,4-diisopropylthioxanthone), a ketal compound (e.g., acetophenone dimethyl ketal and benzyl dimethyl ketal), a benzophenone compound (e.g., benzophenone), a xanthone compound, and a phosphine oxide compound (e.g., 2,4,6-trimethylbenzoyldiphenylphosphine oxide). These photopolymerization initiators may be used alone or in combination.

The ratio of the polymerization initiator relative to 100 parts by weight of the vinyl component ((meth)acrylic component) may be about 0.01 parts by weight to 10 parts by weight, preferably about 0.05 to 5 parts by weight, and more preferably about 0.1 to 2.5 parts by weight.

Incidentally, the photopolymerization initiator may be used in combination with a photosensitizer. The photosensitizer may include a conventional component, for example, a tertiary amine [e.g., a trialkylamine, a trialkanolamine (e.g., triethanolamine), an alkyl dialkylaminobenzoate such as ethyl N,N-dimethylaminobenzoate or amyl N,N-dimethylaminobenzoate, and a bis(dialkylamino)benzophenone such as 4,4-bis(dimethylamino)benzophenone (Michler's ketone) or 4,4'-diethylaminobenzophenone], a phosphine compound such as triphenylphosphine, a toluidine compound such as N,N-dimethyltoluidine, and an anthracene compound such as 9,10-dimethoxyanthracene, 2-ethyl-9,10-dimethoxyanthracene, or 2-ethyl-9,10-diethoxyanthracene. The photosensitizers may be used alone or in combination.

The amount of the photosensitizer relative to 100 parts by weight of the photopolymerization initiator may for example be about 0.1 to 100 parts by weight and preferably about 0.5 to 80 parts by weight.

The thickness of the anchor layer is not particularly limited to a specific one. For example, the thickness of the anchor layer may be about 0.1 to 10 µm, preferably about 0.5 to 8 µm, and more preferably about 1 to 5 µm (e.g., about 2 to 3 µm). An anchor layer having an excessively small thickness tends to be short of uniformity. An anchor layer having an excessively large thickness tends to curl large.

### [Barrier layer]

The barrier layer is not particularly limited to a specific one as far as the barrier layer contains a metal or a metal compound. Preferably the metal or the metal compound is capable of forming a thin film (in particular, a transparent thin film). The metal may include, for example, a group 2A element of the Periodic Table (such as beryllium, magnesium, calcium, strontium, or barium); a transition element of the Periodic Table (such as titanium, zirconium, ruthenium, hafnium, tantalum, or copper); a group 2B element of the Periodic Table (such as zinc); a group 3B element of the Periodic Table (such as aluminum, gallium, indium, or thallium); a group 4B element of the Periodic Table (such as silicon, germanium, or tin); and a group 6B element of the Periodic Table (such as selenium or tellurium). Moreover, as the metal compound, there may be mentioned an oxide of the metal, a nitride of the metal, an oxynitride of the metal, a halide of the metal, a carbide of the metal, and others. These metals or metal compounds may be used alone or in combination. Among these metals or metal compounds, in the respect that not only gas barrier properties but also transparency can be improved, a metal oxide of a group 3B element (such as aluminum) or a group 4B element (such as silicon) of the Periodic Table, a metal oxynitride thereof, or a metal nitride thereof (e.g., silicon oxide [composition formula SiₓO_{y}], aluminum oxide [composition formula AlₓO_{y}], or a silicon nitride [composition formula SiₓN_{y}], silicon oxynitride [composition formula SiₓO_{y}N_{z}]) is preferred. A further preferred metal or metal compound may include a metal oxide (e.g., a metal oxide of a group 3B or 4B element of the Periodic Table, such as silicon oxide or aluminum oxide).

The thickness of the barrier layer can suitably be selected according to a film-forming means (or method). For example, the thickness of the barrier layer may be about 10 to 300 nm (e.g., about 20 to 300 nm), preferably about 15 to 250 nm (e.g., about 20 to 200 nm), and more preferably about 25 to 150 nm (e.g., about 50 to 100 nm, and particularly about 60 to 90 nm). In particular, in order to prevent the generation of cracks, form a uniform film, and hold or maintain gas barrier properties, it is preferable that the thickness of the barrier layer be adjusted to about 10 to 100 nm (e.g., about 15 to 80 nm, and particularly about 20 to 50 nm) for a physical vapor deposition, and it is preferable that the thickness of the barrier layer be adjusted to about 50 to 300 nm (e.g., about 80 to 250 nm, and particularly about 100 to 200 nm) for a chemical vapor deposition.

The gas barrier film of the present invention may further comprise a layer, e.g., a coat layer (such as a hardcoat layer or an overcoat layer) and a conductive layer (such as a transparent conductive layer). Specifically, the gas barrier film may comprise at least one layer selected from these layers or may comprise these layers in combination.

### [Coat layer]

The coat layer is not particularly limited to a specific one and is usually formed as an outer layer of the base film or the barrier layer. As a material for the coat layer, an organic material such as a thermoplastic polymer or a thermosetting polymer is widely used. The coat layer may be a hardcoat layer formed on a second side of the base film, where the anchor layer is formed on the first side of the base film. The formation of the hardcoat layer can prevent curling of the gas barrier film.

The hardcoat layer may be formed with a coating composition containing a thermoplastic polymer and/or a thermosetting polymer. For example, the hardcoat layer may be formed with a polymerizable composition containing a vinyl monomer and/or a vinyl prepolymer (e. g. , a composition as exemplified in the above-mentioned item "Anchor layer") . Incidentally, in order to prevent the gas barrier film from curling, the hardcoat layer is preferably formed to provide almost the same contractility at the both sides of the base film. The hardcoat layer may be different from or the same as the anchor layer.

Moreover, the coat layer may be an overcoat layer formed on the barrier layer. Since the overcoat layer can prevent cracks of the barrier layer even if a mechanical external force is applied, the overcoat layer can protect the barrier layer. The overcoat layer is usually formed on the barrier layer directly.

The organic material of the overcoat layer may include, for example, a thermoplastic polymer [for example, a (meth)acrylic polymer (e.g., a homopolymer such as a poly(methyl methacrylate) or a poly acrylate, and a methyl methacrylate-acrylate copolymer), a polycarbonate, a polyester (e.g., a homo- or copolyester containing phthalic acid or methyl phthalate as a dicarboxylic acid component), a cardo polymer (e.g., a fluorene polyester), a polystyrene (e.g., a styrene homopolymer and a styrene-acrylonitrile copolymer), a polyolefin (e.g., a polyethylene, a polypropylene, and a polymethylpentene), a poly (phenylene ether), and a poly(vinyl acetal) (e.g., a poly(vinyl butyral)], a thermosetting polymer [for example, a phenol polymer, an epoxy polymer, a diethylene glycol bis(allyl carbonate) polymer, a cyanate polymer (a cyanic acid ester polymer), and a polyimide (e.g., a bismaleimide polymer)], and an organic inorganic hybrid material using a sol-gel process. Moreover, the organic material may also include a polymer modified with an acrylonitrile-butadiene rubber and a polymer modified with a polyfunctional acrylate compound, or others (e. g. , an acryl-modified vinyl chloride polymer/acryl-modified urethane polymer/ABS polymer), a thermosetting polymer modified with a thermoplastic polymer [e.g., a crosslinked polyethylene, a crosslinked polyethylene/epoxy polymer, a crosslinked polyethylene/cyanate polymer, a polyphenylene ether/epoxy polymer, and a polyphenylene ether/cyanate polymer], and others. These organic materials may be used alone or in combination.

The thickness of the coat layer (such as a hardcoat layer or an overcoat layer) is not particularly limited to a specific one. For example, the thickness of the coat layer may be about 0.1 to 10 µm, preferably about 0.5 to 8 µm, and more preferably about 1 to 5 µm (e.g., about 2 to 3 µm).

### [Conductive layer]

The gas barrier film of the present invention is preferably available as a member of an electronic device. When the gas barrier film comprises a conductive layer (e. g. , a transparent conductive layer), the gas barrier film is available as a gas barrier conductive member [for example, a gas barrier electrode (e.g. , a transparent electrode)], and others. The conductive layer may be formed as at least one outermost layer of the gas barrier film.

The conductive layer can form at least one selected from the group consisting of an inorganic material and an organic material. The inorganic material may for example be a conductive inorganic compound such as a metal oxide [e.g., an indium oxide (such as In₂O₃ or In₂O₃-SnO₂ complex metal oxide (ITO)), a tin oxide (such as SnO₂, SnO₂-Sb₂O₅ complex metal oxide, or fluorine-doped tin oxide (FTO)), and a zinc oxide (such as ZnO or ZnO-Al₂O₃ complex metal oxide)] or a metal (e.g., gold, silver, platinum, and palladium). These inorganic materials may be used alone or in combination. Among these inorganicmaterials, ametal oxide such as ITO is widely used.

The organic material may include a conductive polymer such as a π-conjugated system polymer [for example, a polyacetylene, a poly(phenylene vinylene), a poly(p-phenylene), a polyacene, a polypyrrole, a polypyridinopyridine, a polypyridine, a polyaniline, a polythiophene, a poly(thienylene vinylene), a poly(ethylenedioxythiophene) (PEDOT), and a poly(diphenylacetylene)]. These organic materials may be used alone or in combination.

The thickness of the conductive layer is not particularly limited to a specific one. The thickness of the conductive layer may be about 1 to 1000 nm (e.g., about 1 to 500 nm), preferably about 5 to 400 nm, and more preferably about 10 to 300 nm.

The surface resistance of the conductive layer may be about 10 to 1000 Ω, preferably about 15 to 500 Ω, and more preferably about 20 to 300 Ω.

The gas barrier film of the present invention has excellent gas barrier properties (in particular, barrier properties against water vapor). For example, the gas barrier film may have a moisture vapor transmission rate of not more than 1.5 g/m²·day (e.g., about 0.00001 to 1.5 g/m²·day), preferably not more than 1.0 g/m²·day (e.g., not more than 0.1 g/m²·day), more preferably not more than 0. 01 g/m²·day (e.g., not more than 0.005 g/m²·day), and particularly not more than 0.001 g/m²·day (e.g., about 0.0001 to 0.001 g/m²·day) under an atmosphere of a temperature of 40°C and a humidity of 90%RH. The gas barrier film of the present invention sometimes shows a moisture vapor transmission rate of substantially not more than the detection limit even if the film is subjected to the after-mentioned moisture vapor transmission test, and thus the film has extremely small barrier properties. Incidentally, the moisture vapor transmission rate may be measured by a common measuring apparatus [for example, "PERMATRAN", "AQUATRAN" (manufactured by MOCON)].

Moreover, the gas barrier film of the present invention also has an excellent transparency. The gas barrier film may have a total light transmittance of not less than 80% (e.g., about 80 to 99.9%), preferably not less than 82% (e.g., about 82 to 99%), and more preferably not less than 85% (e.g., about 85 to 95%) in accordance with JIS (Japanese Industrial Standards) K7105.

### [Process for producing gas barrier film]

The gas barrier film of the present invention may be produced by a common process. Depending on the stacked (or laminated) structure, the order of stack (or lamination) is not particularly limited to a specific one. The gas barrier film is usually obtained by applying a polymerizable composition containing at least a silicone (meth)acrylate component as a vinyl component (particularly a (meth)acrylic component) on at least one side of a base film, then curing the composition to forman anchor layer, and forming a barrier layer containing a metal or a metal compound on the anchor layer.

In the method for forming the anchor layer, the method for applying the polymerizable composition is not particularly limited to a specific one and may include a common applying method, for example, air knife coating, roll coating, gravure coating, blade coating, dip coating, spraying, and spin coating. After applying (or coating), the film may be dried if necessary. The drying may for example be conducted at a temperature of about 50 to 150°C, preferably about 60 to 140°C, and more preferably about 70 to 130°C.

The polymerizable composition may be heated for curing depending on the species of the polymerization initiator. The polymerizable composition can usually be cured by irradiation with an actinic ray. As the actinic ray, heat and/or a light energy ray is available. In particular, the light energy ray is useful. As the light energy ray, there may be used a radial ray or a radioactive ray (such as a gamma ray or an X-ray), an ultraviolet ray, a visible ray, and others. The energy ray is usually an ultraviolet ray in many cases. For example, the light source to be used for the ultraviolet ray may include a Deep UV lamp, a low-pressure mercury lamp, a high-pressure mercury lamp, a superhigh-pressure mercury lamp, a halogen lamp, and a laser light source (a light source such as a helium-cadmium laser or an excimer laser). The quantity of the irradiated light (irradiation energy) varies depending on the thickness of the coated layer. The quantity of the irradiated light may for example be about 50 to 10000 mJ/cm², preferably about 70 to 7000 mJ/cm², and more preferably about 100 to 5000 mJ/cm².

The barrier layer may be formed by a common film-forming means (or method) without limitation as far as the means allows a thin film containing a metal or a metal compound to be formed. The film-forming means may include, for example, a physical vapor deposition (PVD) [for example, a vacuum deposition, an electron beam deposition, an ion beam deposition, an ion plating (e.g., an HCD, an electron beam RF, and an arc discharge), a sputtering (e.g., a direct-current discharge, a radio-frequency (RF) discharge, and a magnetron), a molecular beam epitaxy, and a laser ablation], a chemical vapor deposition (CVD) [for example, a thermal CVD, a plasma CVD, an MOCVD (organic metal vapor-phase growth), and a photo-assisted CVD], an ion beam mixing, and an ion implantation. Among these film-forming means, a physical vapor deposition (such as vacuum deposition, ion plating, or sputtering), a chemical vapor deposition, and others are widely used. A sputtering or a plasma CVD is preferred.

The sputtering can be carried out in a common condition. For example, the degree of vacuum (or the initial degree of vacuum) is about 0.1 x 10⁻⁴ to 100 x 10⁻⁴ Pa and preferably 1 x 10⁻⁴ to 10 x 10⁻⁴ Pa. As an introduction gas, for example, there may be used an inert gas (such as helium, neon, argon, or xenon); air, oxygen, nitrogen, carbon monoxide, carbon dioxide, nitrogen monoxide, and sulfur dioxide. The introduction gas may be a mixed gas containing an inert gas and oxygen in a ratio of about 1 to 50% (preferably about 3 to 30% and more preferably about 5 to 20%) of the oxygen relative to the inert gas. The applied voltage is, for example, about 0.1 to 100 kV and preferably about 1 to 50 kV. The temperature is usually about 50 to 250°C. Incidentally, the sputtering may be carried out by a common apparatus (for example, "QuanteraSXM" manufactured by PHI).

The CVD (plasma CVD) can also be carried out in a common condition. For example, the metal or the metal compound may be deposited by using a halide corresponding to the metal or the metal compound and a reactive gas (such as air, oxygen, nitrogen, carbon monoxide, carbon dioxide, nitrogen monoxide, or sulfur dioxide). The pressure of a reactor is about 0.1 x 10⁻⁴ to 100 x 10⁻⁴ Pa and preferably 1x10⁻⁴ to 10 x 10⁻⁴ Pa. The applied voltage is, for example, about 0.1 to 100 kV and preferably about 1 to 50 kV. The temperature is usually about 50 to 250°C. Incidentally, the CVD may be carried out by a common apparatus (for example, "ICP-CVD" manufactured by SELVAC. Co. Ltd.).

The coat layer (such as a hardcoat layer or an overcoat layer) may be formed in the same manner as in the method for forming the anchor layer. Moreover, the conductive layer can be formed by a common method depending on the component(s).

### [Electronic device]

The electronic device of the present invention is provided with the gas barrier film as a gas barrier member. The electronic device may for example be a liquid crystal element, a thin-film solar cell, an organic EL device, and an electronic paper. Fig. 4 is a schematic cross-sectional view showing an organic EL device provided with a gas barrier film as a gas barrier member in accordance with an embodiment of the present invention. In this embodiment, the organic EL device has a gas barrier film 40 (50) on each side thereof; the gas barrier film 40 (50) comprises a base film 41 (51), an anchor layer 42 (52), and a barrier layer 43 (53) which are stacked (or laminated) in this order; and each base film of these gas barrier films is in contact with the organic EL device. Specifically, an organic EL device 60 is disposed between these (a pair of) gas barrier films at a central region of the surfaces of these base films which face each other. The organic EL device 60 comprises a transparent electrode 65a, an organic light-emitting layer 66 (a laminate comprising an electron-transporting layer and a hole-transporting layer, and if necessary a light-emitting layer) formed (or laminated) on the transparent electrode 65a, and a metal electrode 65b formed (or laminated) on the organic light-emitting layer 66. These gas barrier films are adhered (or bonded) through an adhesive layer 67 at both edges of the organic EL device.

Since the gas barrier films having excellent gas barrier properties (particularly, barrier properties against water vapor) and transparency are disposed on both sides of the organic EL device, permeation of external water vapor and contact of the water vapor with the organic EL device can be prevented without blocking of light transmission, so that the deterioration of the device performance can effectively be inhibited.

Incidentally, the pair of the gas barrier films may be so disposed that the base films are opposite each other or so disposed that the barrier layers are opposite each other. Moreover, one or a plurality of (e.g., 2 to 4) gas barrier films may be used as far as part or whole of the periphery of the organic EL device is covered with the gas barrier film.

Incidentally, as other electronic devices, for example, the electronic paper usually has a laminated structure which comprises a thin film transistor (TFT) base, a display layer comprising a microcapsule or a silica bead and being formed on the base, and a transparent electrode formed on the display layer. Moreover, the thin-film solar cell usually has a laminated structure which comprises a transparent electrode, a deposition film (such as a phthalocyanine deposition film or a fullerene deposition film) formed on the transparent electrode, a conductive electrode (such as an aluminum electrode) formed on the deposition film, and a sealing film (such as LiF) formed on the conductive electrode. The gas barrier film of the present invention may also be used as a component of these electronic devices. For example, the gas barrier film may be formed on the transparent electrode. Incidentally, the base film of the gas barrier film may be in contact with the transparent electrode, or the barrier layer of the gas barrier filmmay be in contact with the transparent electrode. Use of the gas barrier film of the present invention for these electronic devices allows external water vapor to be cut off without blocking of the light transmission and prevents the device performance from deteriorating over a long period of time.

### EXAMPLES

The following examples are intended to describe this invention in further detail and should by no means be interpreted as defining the scope of the invention.

Gas barrier films of Examples and Comparative Examples were tested for the following characteristics.

### [Moisture vapor transmission rate]

The moisture vapor transmission rate was measured using a moisture vapor transmission rate measuring apparatus ("PERMATRAN-W3/33" manufactured by MOCON, for the gas barrier films of Examples 1 and 3 to 5 and Comparative Examples 1 to 5; "AQUATRAN" manufactured by MOCON, for the gas barrier film of Example 2). The measurement condition is 40°C and a relative humidity of 90%RH.

### [Total light transmittance]

The total light transmittance was measured using a haze meter (manufactured by Nippon Denshoku Industries Co., Ltd., NDH-300A) in accordance with JIS K7105.

### Example 1

A urethane (meth)acrylate (manufactured by DAICEL-CYTEC Company, Ltd., "EBECRYL1290") as a silicon-free vinyl component, a silicone di (meth) acrylate (manufactured by DAICEL-CYTEC Company, Ltd., "EBECRYL350") as a silicone (meth)acrylate component, and a polymerization initiator (manufactured by Ciba Japan K.K., "IRGACURE184") were mixed in a ratio of 96/2/2 (weight ratio) to prepare a liquid coating composition. The liquid coating composition was applied on both sides of a base film (a PET film, manufactured by Mitsubishi Plastics, Inc., 188 µm thick) and dried, then irradiated and cured with UV at 300 mJ/cm² to form first and second anchor layers, each having a thickness of 5 µm. Aluminum oxide [composition AlₓO_{y}] was deposited onto the first anchor layer by a sputtering (the degree of vacuum of 5 x 10⁻⁴ Pa, oxygen concentration of 15%) to form a barrier layer having a thickness of 20 nm. Thus a gas barrier film was produced. The evaluation of the resulting gas barrier film is shown in Table 1.

### Example 2

The silicon-free vinyl component, the silicone (meth) acrylate component, and the polymerization initiator were mixed in a ratio of 94/4/2 (weight ratio) to prepare a liquid coating composition. A gas barrier film was produced in the same procedure as Example 1 except that this liquid coating composition was used and that the barrier layer having a thickness of 50 nm was formed. The evaluation of the resulting gas barrier film is shown in Table 1.

### Example 3

The silicon-free vinyl component, the silicone (meth) acrylate component, and the polymerization initiator were mixed in a ratio of 86/12/2 (weight ratio) to prepare a liquid coating composition. A gas barrier film was produced in the same procedure as Example 1 except that this liquid coating composition was used. The evaluation of the resulting gas barrier film is shown in Table 1.

### Example 4

A gas barrier film was produced in the same procedure as Example 2 except that a silicon oxynitride [composition SiₓO_{y}N_{z}] was deposited using SiCl₄, O₂, and N₂ by a plasma CVD [CVD apparatus (SELVAC. Co. Ltd., ICP-CVD)] to form a barrier layer having a thickness of 70 nm. The evaluation of the resulting gas barrier film is shown in Table 1.

### Example 5

A gas barrier film was produced in the same procedure as Example 2 except that a silicon nitride [composition SiₓN_{y}] was deposited using SiCl₄ and N₂ by a plasma CVD [CVD apparatus (SELVAC. Co. Ltd., ICP-CVD)] to form a barrier layer having a thickness of 70 nm. The evaluation of the resulting gas barrier film is shown in Table 1.

### Comparative Example 1

Aluminum oxide [composition AlₓO_{y}] was deposited onto one side of a base film (a PET film, manufactured by Mitsubishi Plastics, Inc., 188 µm thick) by a sputtering (the degree of vacuum of 5 x 10⁻⁴ Pa, oxygen concentration of 15%) to form a barrier layer having a thickness of 20 nm. Thus a gas barrier film was produced. The evaluation of the resulting gas barrier film is shown in Table 1.

### Comparative Example 2

The silicon-free vinyl component, the silicone (meth)acrylate component, and the polymerization initiator were mixed in a ratio of 98/0/2 (weight ratio) to prepare a liquid coating composition. A gas barrier film was produced in the same procedure as Example 1 except that this liquid coating composition was used. The evaluation of the resulting gas barrier film is shown in Table 1.

### Comparative Example 3

The silicon-free vinyl component, the silicone (meth)acrylate component, and the polymerization initiator were mixed in a ratio of 98/0/2 (weight ratio) to prepare a liquid coating composition. A gas barrier film was produced in the same procedure as Example 4 except that this liquid coating composition was used. The evaluation of the resulting gas barrier film is shown in Table 1.

### Comparative Example 4

The silicon-free vinyl component, the silicone (meth) acrylate component, and the polymerization initiator were mixed in a ratio of 98/0/2 (weight ratio) to prepare a liquid coating composition. A gas barrier film was produced in the same procedure as Example 5 except that this liquid coating composition was used. The evaluation of the resulting gas barrier film is shown in Table 1.

### Comparative Example 5

A gas barrier film was produced in the same procedure as Comparative Example 2 except that aluminum was deposited by a vacuum deposition to form a barrier layer having a thickness of 80 nm. The evaluation of the resulting gas barrier film is shown in Table 1.

[Table 1]

**Table 1**

| | Silicon-free vinyl component (parts by weight) | Silicone (meth)acrylate component (parts by weight) | Polymerization initiator (parts by weight) | Deposition means | Deposition species | Moisture vapor transmission rate (g/m²·day)) | Total light transmittance (%) |
|---|---|---|---|---|---|---|---|
| Example 1 | 96 | 2 | 2 | Sputtering | Alₓ O_{y} | less than 0.005 (not more than confidence limit) | 90.5 |
| Example 2 | 94 | 4 | 2 | | | 0.001 | 90.3 |
| Example 3 | 86 | 12 | 2 | | | 0.05 | 90.2 |
| Example 4 | 94 | 4 | 2 | Plasma CVD | SiₓO_{y}N_{z} | 0.07 | 90.1 |
| Example 5 | 94 | 4 | 2 | | SiₓN_{y} | 0.03 | 90.2 |
| Example 5 Comparative Example 1 | - | - | - | Sputtering | AlₓO_{y} | 0.35 | 90.6 |
| Comparative Example 2 | 98 | - | 2 | | | 0.21 | 90.8 |
| Comparative Example 3 | 98 | - | 2 | Plasma CVD | SiₓO_{y}N_{z} | 0.54 | 90.0 |
| Comparative Example 4 | 98 | - | 2 | | Si_{y}N_{z} | 0.12 | 90.2 |
| Comparative Example 5 | 98 | - | 2 | Vacuum deposition | Al | 1.06 | 2.1 |

As apparent from Table 1, compared with the films of Comparative Examples, the films of Examples have significantly low moisture vapor transmission rate and excellent transparency.

### INDUSTRIAL APPLICABILITY

The gas barrier film of the present invention has excellent gas barrier properties and is widely applicable to various packing materials (for example, packing materials for microwave food, pouch-packed food, frozen food, microwave sterilization, flavor barrier, pharmaceutical product, and precision electronic part). Moreover, the gas barrier film of the present invention has particularly excellent barrier properties against water vapor and high transparency and is preferably available for an electronic device (for example, a liquid crystal element, a thin-film solar cell, an organic EL device, an electronic paper, and touch panel) as a gas barrier member.

### DESCRIPTION OF REFERENCE NUMERALS

- 10, 20, 30, 40, 50: Gas barrier film
- 11, 21, 31, 41, 51: Base film
- 12, 22a, 22b, 32, 42, 52: Anchor layer
- 13, 23a, 23b, 33, 43, 53: Barrier layer
- 34: Overcoat layer
- 60: Organic EL device
- 65a: Transparent electrode
- 65b: Metal electrode
- 66: Organic light-emitting layer
- 67: Adhesive Layer

## Claims

1. A gas barrier film comprising
a base film,
an anchor layer formed on at least a first side of the base film, the anchor layer being formed from a cured product of a polymerizable composition containing at least one vinyl component selected from the group consisting of a vinyl monomer and a vinyl prepolymer, and
a barrier layer formed on the anchor layer, the barrier layer containing a metal or a metal compound,
wherein the vinyl component contains at least one a first vinyl component selected from the group consisting of a silicone (meth)acrylate monomer and a silicone (meth)acrylate prepolymer.

2. A gas barrier film according to claim 1, wherein the vinyl component comprises
at least one first vinyl component selected from the group consisting of a silicone (meth)acrylate monomer and a silicone (meth)acrylate prepolymer and
at least one second vinyl component selected from the group consisting or a silicon-free vinyl monomer and a silicon-free vinyl prepolymer.

3. A gas barrier film according to claim 2, wherein the second vinyl component comprises a urethane (meth)acrylate.

4. A gas barrier film according to claim 2 or 3, wherein the weight ratio of the first vinyl component relative to the second vinyl component is 1/99 to 30/70 as a ratio of the former/the latter.

5. A gas barrier film according to any one or claims 1 to 4, wherein the barrier layer comprises at least one metal compound, selected, from the group consisting of a metal oxide, a metal oxynitride, and a metal nitride.

6. A gas barrier film according to any one of claims 1 to 5, wherein the barrier layer is formed by a film-forming means selected from the group consisting of a vacuum deposition, an ion plating, a sputtering, and a chemical vapor deposition, and the barrier layer has a thickness of 20 to 300 nm.

7. A gas barrier film according to any one of claims 1 to 6, wherein the base film comprises at least one member selected form the group consisting of a polyester and a polycarbonate.

8. A gas barrier film according to any one of claims 1 to 7, which further comprises a hardcoat layer formed on a second side of the base film, wherein the hardcoat layer is formed from a cured product of polymerizable composition containing at least one of a vinyl monomer and a vinyl prepolymer.

9. A gas barrier film according to any one of claims 1 to 8, wherein the anchor layer and the barrier layer formed on the anchor layer form a unit, and the first side of the base film has a plurality of the units in the form of stacking.

10. A gas barrier film according to any one of claims 1 to 9, which further comprises an overcoat layer formed on the barrier layer wherein the overcoat layer is formed from an organic material.

11. A gas barrier film according to any one of claims 1 to 10, which comprises a conductive layer formed as at least one outermost layer.

12. A process for producing a gas barrier film recited in any one of claims 1 to 11, which comprises
forming an anchor layer by applying a polymerizable composition containing at least one or a silicone (meth)acrylate monomer and a silicone (meth)acrylate prepolymer on at least a first side of a base film and then curing the polymerizable composition, and
forming a barrier layer containing a metal or a metal compound on the anchor layer.

13. An electronic device provided with a gas barrier film recited in any one of claims 1 to 11 as a gas barrier member.

14. An electronic device according to claim 13, which is a liquid crystal element, a thin-film solar cell, an organic EL device, or an electronic paper.
